# EUROPEAN PATENT APPLICATION

(11) **EP 4 811 421 A1**
(43) Date of publication of application: **23.09.2026**
(21) Application number: 24891223.0
(22) Date of filing: 30.10.2024
(51) Int. Cl.: H01L 21/365, C23C 16/455

(54) **VAPOR PHASE GROWTH DEVICE**

(30) Priority: 17.11.2023 JP 2023196091
(71) Applicant: Taiyo Nippon Sanso Corporation, Tokyo 142-8558 (JP)
(72) Inventor: IKENAGA Kazutada, Tokyo 142-8558 (JP); YAMADA Sadahiro, Tokyo 142-8558 (JP)
(74) Representative: HGF
(86) International application number: PCT/JP2024/038710
(87) International publication number: WO 2025/105182

(57) **Abstract**

The present invention provides a vapor phase growth device that can reduce costs and further increase productivity. The present invention provides a vapor phase growth device (1) including: a flow channel (10) and a partition plate (12). The flow channel (10) includes a gas passage (14) for guiding a raw material gas, and a substrate is disposed in the gas passage (14), and a raw material gas is guided to the substrate surface (2a) through the gas passage (14). The partition plate (12) partitions the gas passage (14) (first gas passage 17) into multiple layers upstream of the surface of the substrate, and the edge at the substrate side of the partition plate (12) is formed into a sloped surface.

## Description

### TECHNICAL FIELD

The present invention relates to a vapor phase growth apparatus.

### BACKGROUND ART

For example, a vapor phase growth device is known in which a substrate is placed in a flow channel, and a raw material gas introduced into the flow channel is caused to flow along a surface of a substrate while the raw material gas is heated, thereby growing a semiconductor thin film on the surface of the substrate. This vapor phase growth device makes it possible to grow a semiconductor thin film on the surface of the substrate (see, for example, Patent Document 1).

### PRIOR ART DOCUMENTS

### PATENT LITERATURE

Patent Document 1: Japanese Patent No. 4474149

### SUMMARY OF INVENTION

### PROBLEM TO BE SOLVED BY THE INVENTION

In a deposition process for forming a semiconductor thin film in a vapor phase growth device, it is ideal for all input raw material to be used to form the film on the substrate.

However, the raw material gases used for semiconductor film deposition are decomposed by the heating required for semiconductor film growth before reaching the substrate. This causes deposits to form on parts near the substrate that do not contribute to the growth of the semiconductor film. These deposits have various effects on the quality of the semiconductor film, such as changes in environmental temperature due to changes in the emissivity of the parts, abnormal film formation due to the deposits, and corrosion of nearby parts. Furthermore, since not all of the raw material is used to form the film on the substrate, there is an issue of increased costs.

Furthermore, deposits upstream of the substrate, in particular, can become a source of particles during the film deposition process, and therefore need to be removed regularly. The time required to remove the deposits poses an issue of reduced productivity.

In view of the circumstances above, an object of the present invention is to provide a vapor phase growth device that can reduce costs and further increase productivity.

### MEANS FOR SOLVING THE PROBLEM

One aspect of the present invention is a vapor phase growth device including: a flow channel including a gas passage for guiding a raw material gas, a substrate disposed in the gas passage, and which is configured to guide the raw material gas to a surface of a substrate through the gas passage; and a partition plate that partitions the gas passage into multiple layers upstream of the surface of the substrate, and the edge of which on the surface side of the substrate is formed into a sloped surface.

In one aspect of the present invention, the sloped surface is inclined away from the surface of the substrate.

In one aspect of the present invention, the plurality of layers is three layers.

In one aspect of the present invention, the partition plate that divides the plurality of layers into three layers are the same length.

In one aspect of the present invention, the surface of the substrate is arranged facing downward.

### EFFECTS OF THE INVENTION

According to the present invention, it is possible to provide a vapor phase growth device that can reduce costs and further increase productivity.

### BRIEF DESCRIPTION OF DRAWINGS

[FIG. 1] A perspective view of a vapor phase growth device according to an embodiment of the present invention.
[FIG. 2] A perspective view of an enlarged portion II of the vapor phase growth device shown in FIG. 1.
[FIG. 3] A cross-sectional view of a vapor phase growth device according to an embodiment of the present invention.
[FIG. 4] A cross-sectional view illustrating the sloped surface of a partition plate according to an embodiment of the present invention.
[FIG. 5] A cross-sectional view illustrating the sloped surface of a partition plate according to comparative embodiment 1.
[FIG. 6] A graph showing the deposition rate of a raw material gas with respect to the distance from an edge of the partition plate.
[FIG. 7] A cross-sectional view illustrating effects due to the length of the partition plate according to an embodiment.
[FIG. 8] A cross-sectional view illustrating effects due to the length of the partition plate according to comparative embodiment 2.
[FIG. 9] A cross-sectional view illustrating effects due to the length of the partition plate according to comparative embodiment 3.
[FIG. 10] A graph showing the growth rate of a raw material gas on the substrate surface with respect to the length of the partition plate.
[FIG. 11] A cross-sectional view illustrating effects due to an inclination angle of the sloped surface of the partition plate according to an embodiment.
[FIG. 12] A cross-sectional view illustrating effects due to the inclination angle of the sloped surface of the partition plate according to comparative embodiment 4.
[FIG. 13] A cross-sectional view illustrating a state in which the sloped surface is not formed on the partition plate according to comparative embodiment 5.
[FIG. 14] A graph showing the deposition rate ratio of the raw material gas on a ceiling with respect to an inclination angle of the partition plate.
[FIG. 15] A cross-sectional view illustrating a low-speed region at the tip of the partition plate according to an embodiment of the present invention.
[FIG. 16] A cross-sectional view illustrating a low-speed region at the edge of the partition plate according to comparative embodiment 4.
[FIG. 17] A cross-sectional view illustrating a low-speed region at the edge of the partition plate according to comparative embodiment 5.

### DETAILED DESCRIPTION OF THE PREFERRED EMBODIMENTS

Embodiments of the present invention will be described below with reference to the accompanying drawings.

### (Vapor Phase Growth Device)

As one embodiment of the present invention, a vapor phase growth device 1 for growing a semiconductor thin film on the surface of a substrate will be described.

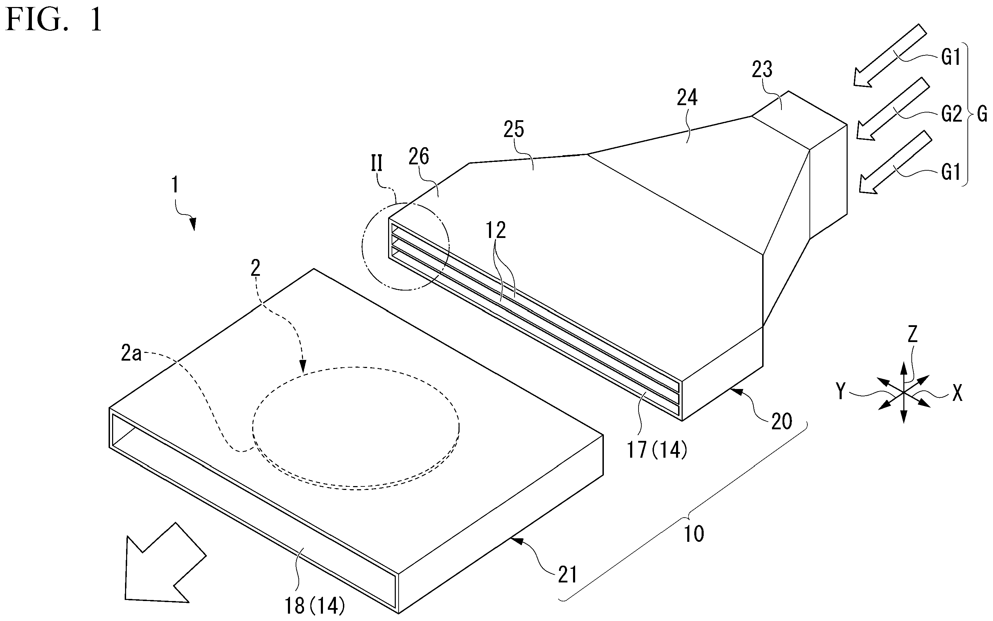

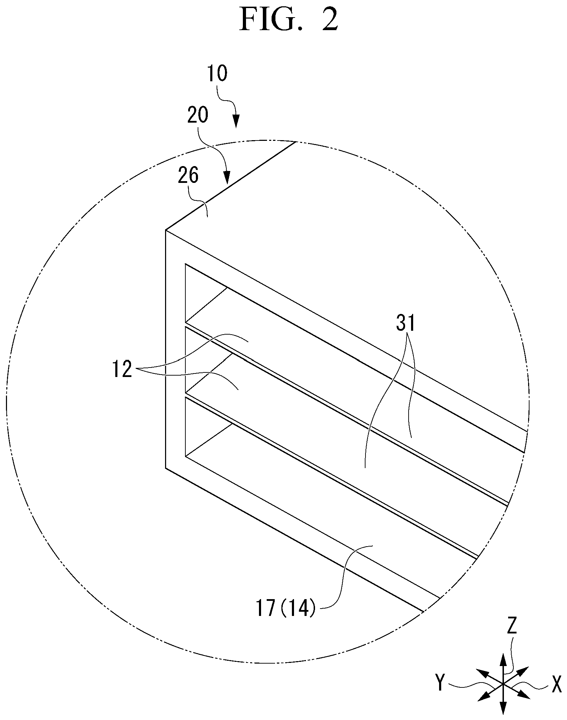

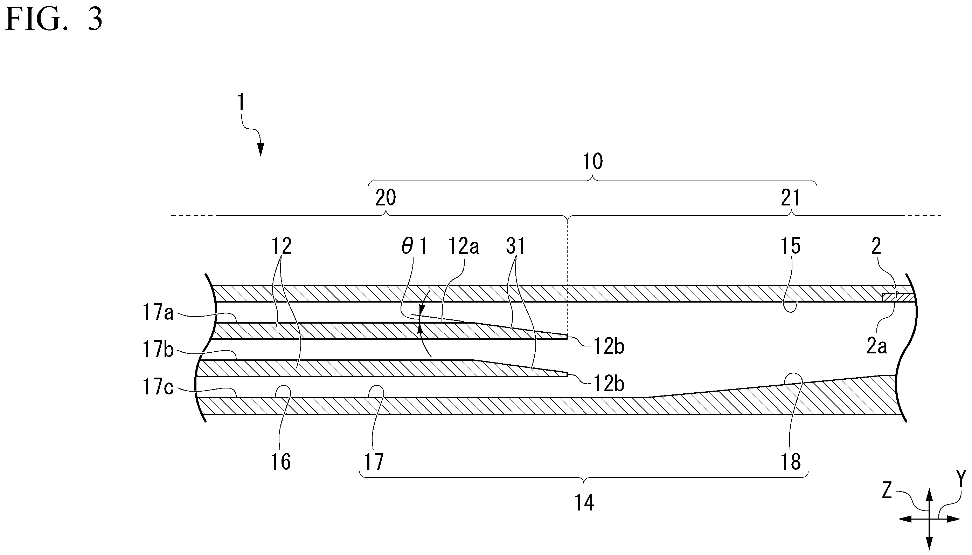

FIG. 1 is a perspective view of a vapor phase growth device according to an embodiment. FIG. 2 is a perspective view of an enlarged view of section II of the vapor phase growth device shown in FIG. 1. FIG. 3 is a cross-sectional view of a vapor phase growth device according to an embodiment.

As shown in FIGS. 1 to 3 , the vapor phase growth device 1 is a chemical vapor phase growth device that flows a raw material gas G along the surface 2 a of a substrate 2 and thermally causes a vapor-phase reaction of the raw material gas G to grow a compound semiconductor thin film on the surface 2 a, which will be used as a material for high-frequency devices, power semiconductors, and the like. In particular, the vapor phase growth device 1 is an apparatus for growing high-quality gallium oxide crystal (Ga₂O₃), which has a high reactivity and a wide band gap that requires high-temperature growth, on a sapphire substrate, a Ga₂O₃ substrate, or the like. Note that, in the present embodiment, an example of growing gallium oxide crystal (Ga₂O₃) on a sapphire substrate, a Ga₂O₃ substrate, or the like will be described, but the present invention is not limited to these embodiments.

The vapor phase growth device 1 includes a flow channel 10 and a partition plate 12. In the following description, a surface 2a of substrate 2 is sometimes referred to as "substrate surface 2a". A compound semiconductor thin film is sometimes referred to as "thin film." In FIG. 1, an arrow X indicates the width direction of the vapor phase growth device 1, an arrow Y indicates the upstream-downstream direction of the vapor phase growth device 1, and an arrow Z indicates the up-down direction of the vapor phase growth device 1.

### (Flow Channel)

The flow channel 10 has a gas passage 14 that guides a raw material gas G to the substrate 2 (substrate surface 2a). In the flow channel 10, the substrate 2 is disposed on the ceiling 15 of the gas passage 14. The flow channel 10 guides the raw material gas G to the substrate surface 2a through the gas passage 14. The flow channel 10 includes a first flow channel 20 and a second flow channel 21.

### (First Flow Channel)

The first flow channel 20 supplies the raw material gas G introduced from a gas inlet pipe (not shown) in a direction parallel to the substrate surface 2a. The first flow channel 20 includes, in order from the gas flow direction of the raw material gas G, a gas inlet section 23, a first flow section 24, a second flow section 25, and a gas outlet section 26. In the first flow channel 20, a first gas passage 17 is formed by the gas inlet section 23, the first flow section 24, the second flow section 25, and the gas outlet section 26.

The first flow section 24 and the second flow section 25 are formed so that their widths gradually increase toward the downstream side in the gas flow direction in a plan view. Furthermore, the first flow section 24 has a shape in which its vertical height gradually decreases toward the downstream side in the gas flow direction in a side view.

The gas inlet section 23 is formed in approximately the same shape as the most upstream section of the first flow section 24. The cross section of the gas inlet section 23 in the gas flow direction is square or nearly square, and a gas inlet pipe (not shown in figures) is inserted into the center.

The gas outlet section 26 guides the raw material gas G flowing out from the second flow section 25 toward the substrate surface 2a. The gas outlet section 26 is formed in a flat shape facing horizontally, similar to the shape of the most downstream section of the second flow section 25. The opening width of the gas outlet section 26 is formed to be larger than the diameter of the substrate 2.

The raw material gas introduced into the gas introduction section 23 from a gas introduction pipe (not shown in figures) is diffused evenly in all directions within the gas introduction section 23 and flows into the first flow section 24. In this first flow section 24, the height dimension gradually decreases while the width dimension gradually increases, so that the flow of raw material gas is pressed down from above and below and spread evenly in the width direction.

Furthermore, when the raw material gas flows into the second flow section 25, its height remains unchanged and only its width expands, so that the flow of raw material gas that tends to diffuse in all directions is suppressed in the vertical direction while facilitating diffusion in the width direction of both side walls. In addition, because both side walls are widened, there is almost no turbulence in the gas flow due to contact with the side walls, and a uniform gas flow can be formed.

### (Second Flow Channel)

The second flow channel 21 is connected to the most downstream portion of the gas blowing section 26. The second flow channel 21 is formed in a horizontally flat shape similar to the shape of the gas blowing section 26. The second flow channel 21 has a second gas passage 18 that communicates with the first gas passage 17 of the first flow channel 20. The first gas passage 17 and the second gas passage 18 form the gas passage 14 of the flow channel 10.

The second flow channel 21 has a substrate 2 arranged on the ceiling 15 side. For example, the substrate surface 2a of the substrate 2 is exposed from the ceiling 15 of the second flow channel 21 to the second gas passage 18 (that is, the gas passage 14). The substrate surface 2a is arranged facing downward. In other words, the vapor phase growth device 1 according to the present embodiment is of a so-called face-down type. Because the vapor phase growth device 1 is of a face-down type, even if deposits occur upstream of the substrate surface 2a or on the opposing surface of the substrate 2, the deposits can be prevented from falling onto the substrate surface 2a.

The raw material gas G is introduced downstream from the gas outlet 26 into the second flow channel 21. The raw material gas G introduced into the second flow channel 21 is guided to the substrate surface 2a through the second gas passage 18 (the gas passage 14).

### (Partition Plate)

At least one partition plate 12 is provided in the first gas passage 17 of the first flow channel 20. In the present embodiment, two partition plates 12 are used as an example of at least one partition plate 12. The number of partition plates 12 is not limited to two. As another example, for example, one partition plate 12 may be provided in the first gas passage 17.

The two partition plates 12 are arranged at a vertical interval in the first gas passage 17. Specifically, of the two partition plates 12, the upper partition plate is arranged at a downward interval from the ceiling 15 of the first flow channel 20. Furthermore, of the two partition plates 12, the lower partition plate 12 is arranged at a downward interval from the upper partition plate 12. Furthermore, the lower partition plate 12 is arranged at an upward interval from the floor 16 of the first flow channel 20.

That is, the first gas passage 17 of the first flow channel 20 is partitioned into multiple layers by the upper partition plate 12 and the lower partition plate 12 on the upstream side of the substrate surface 2a. Specifically, the first gas passage 17 of the first flow channel 20 is partitioned by the upper partition plate 12 and the lower partition plate 12 from top to bottom into three layers of passages: a first passage 17a, a second passage 17b, and a third passage 17c. The second passage 17b is the central passage of the three layers. The first passage 17a and the third passage 17c are passages on both sides in the vertical direction.

In the gas introduction part 23, oxygen (O₂ + carrier gas (inert gas such as Ar)) G1 of the raw material gas G is introduced into the first passage 17a and the third passage 17c. In addition, in the gas introduction part 23, an organometallic compound (organometallic compound + carrier gas (inert gas such as Ar)) G2 of the raw material gas G is introduced into the second passage 17b. Note that in the present embodiment, trimethylgallium (TMG) G2 is used as an example of the organometallic compound G2, but the organometallic compound G2 is not limited to trimethylgallium G2.

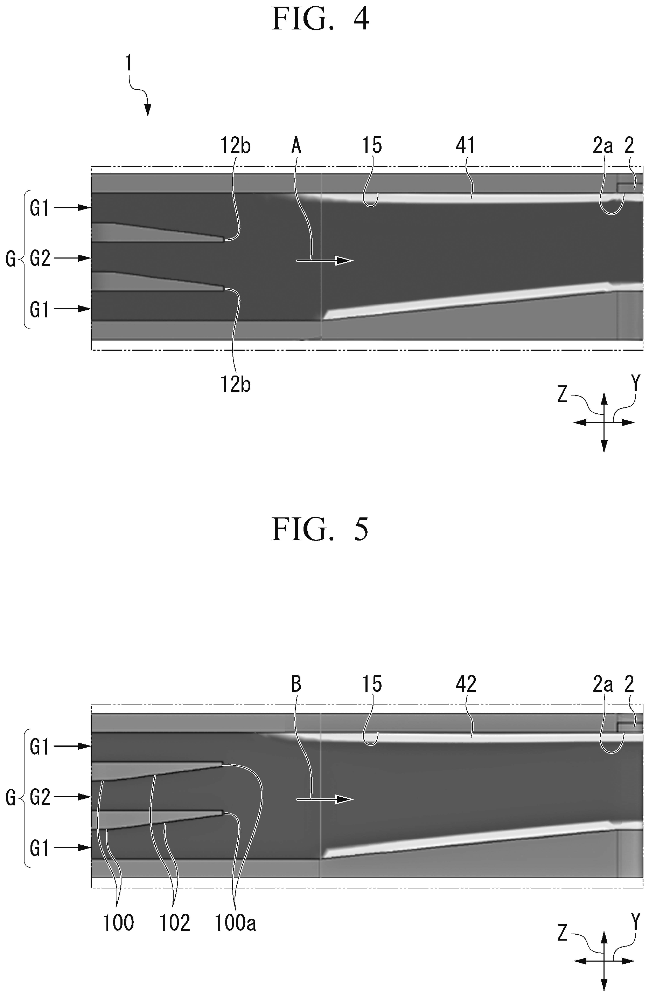

The two partition plates 12 are formed to have the same shape. In the following description, the upper partition plate 12 will be abbreviated as "partition plate 12," and a description of the lower partition plate 12 will be omitted. The partition plate 12 has a sloped surface 31 at its edge. The sloped surface 31 is formed so that the upper surface 12a of the partition plate 12 on the substrate surface 2a side slopes downward toward the downstream side. In other words, the sloped surface 31 is sloped downward in a direction away from the substrate surface 2a. The reason for sloping the sloped surface 31 in a direction away from the substrate surface 2a will be explained in detail with reference to FIGS. 4 to 6.

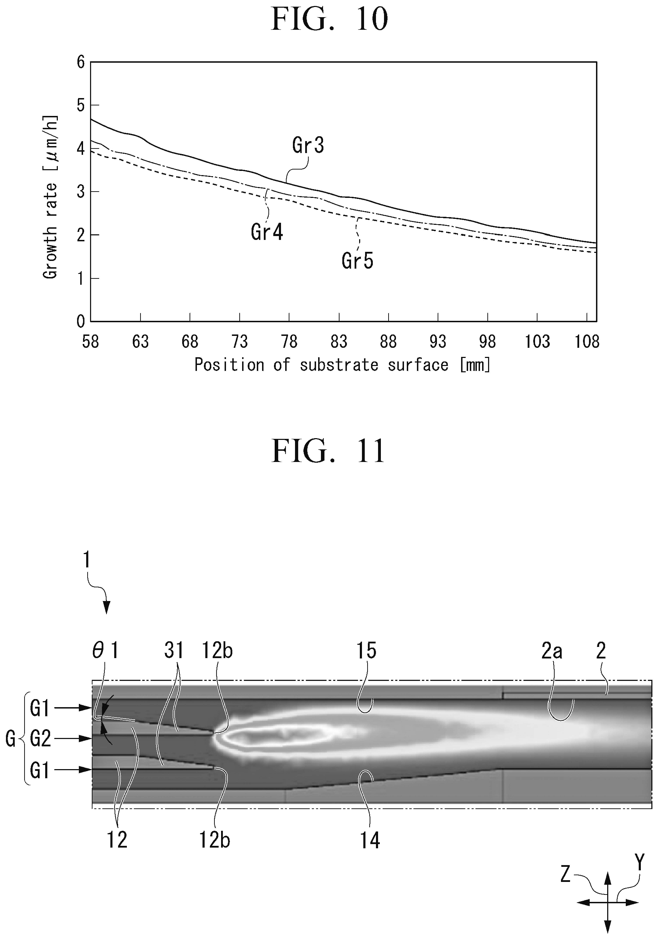

The sloped surface 31 is formed at an inclination angle θ1 with respect to the upper surface 12a of the partition plate 12. The inclination angle θ1 of the sloped surface 31 is set, for example, in the range of θ1 = 3° to 30°. It is more preferable that the inclination angle θ1 be set in the range of θ1 = 3° to 8°. The reason for setting the inclination angle θ1 in the range of 3° to 30° will be explained in detail with reference to FIGS. 11 to 17.

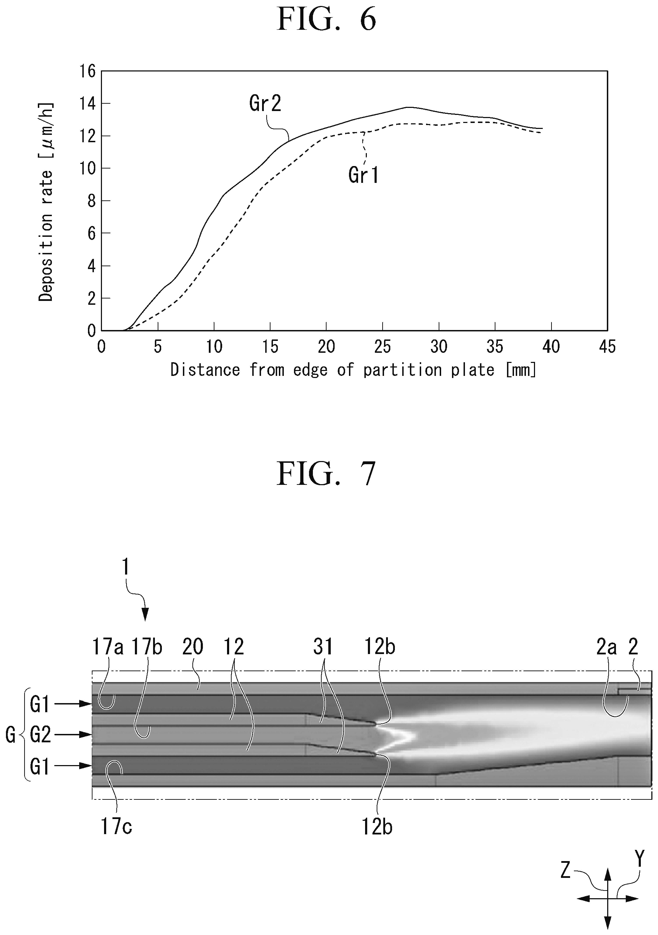

The upper partition plate 12 and the lower partition plate 12 are formed to have the same length in the flow direction (Y direction) of the raw material gas G. That is, the edge 12b of the upper partition plate 12 and the edge 12b of the lower partition plate 12 are disposed at the same position in the up-down direction. The reason for forming the upper partition plate 12 and the lower partition plate 12 to have the same length will be explained in detail with reference to FIGS. 6 to 10.

### (Sloped Surface of Partition Plate)

Next, the reason for inclining the sloped surface 31 of the partition plate 12 away from the substrate surface 2a will be explained in detail with reference to FIGS. 4 to 6.

FIG. 4 is a cross-sectional view illustrating the sloped surface of a partition plate according to an embodiment.

As shown in FIG. 4, the sloped surface 31 at the edge of the partition plate 12 according to the present embodiment is inclined away from the substrate surface 2a. The raw material gas G is introduced near the downstream side of the partition plate 12, as indicated by arrow A. The introduced raw material gas G grows as deposits 41 on the ceiling 15 near the downstream side (that is, upstream of the substrate surface 2a).

FIG. 5 is a cross-sectional view illustrating the sloped surface of the partition plate according to comparative embodiment 1.

As shown in FIG. 5, the partition plate 100 of comparative embodiment 1 is inclined so that the sloped surface 102 at its edge approaches the substrate surface 2a. The raw material gas G is introduced near the downstream side of the partition plate 100, as indicated by arrow B. The introduced raw material gas G grows as deposits 42 on the ceiling 15 near the downstream side (that is, upstream of the substrate surface 2a).

Simulations were performed to investigate differences in the deposition of the raw material gas on the ceiling plate caused by differences in the shape of the partition plate. FIG. 6 is a graph showing the deposition rate of the raw material gas with respect to the sloped surface of the partition plate. In FIG. 6, the vertical axis shows the deposition rate on the ceiling 15. The horizontal axis indicates the downstream position on the ceiling from the edges 12b, 100a of the partition plates 12, 100. Graph Gr1 is a graph showing the deposition state when the partition plate 12 according to the present embodiment is used. Graph Gr2 is a graph showing the deposition state when the partition plate 100 according to comparative embodiment 1 is used.

As shown in FIGS. 4 to 6, it can be seen that the deposition rate in graph Gr2 of comparative embodiment 1 is higher than the deposition rate in graph Gr1 of the present embodiment. That is, the partition plate 100 of comparative embodiment 1 grows deposits 42 faster near the downstream side of the partition plate 100 (upstream side of the substrate surface 2a) than the partition plate 12 of the present embodiment. Therefore, the partition plate 100 of comparative embodiment 1 has more deposits 42 adhere to the upstream side of the substrate surface 2a than the partition plate 12 of the present embodiment.

As a result, the partition plate 12 of the present embodiment can reduce the amount of deposits 41 on the upstream side of the substrate surface 2a compared to the partition plate 100 of comparative embodiment 1. Therefore, the partition plate 12 of the present embodiment can efficiently grow a thin film on the substrate surface 2a. Furthermore, the reproducibility of the growth rate for growing a thin film on the substrate surface 2a can be ensured satisfactorily.

### (Partition Plate Length)

Next, the reason for forming the partition plates 12 to the same length will be explained in detail with reference to FIGS. 7 to 10.

FIG. 7 is a cross-sectional view illustrating effects due to the length of the partition plates according to the present embodiment.

As shown in FIG. 7, the upper and lower partition plates 12 in the present embodiment are formed to the same length. In the first flow channel 20 of the present embodiment, oxygen (O₂ + carrier gas (an inert gas such as Ar)) G1 in the raw material gas G is introduced into the first passage 17a and the third passage 17c. Furthermore, trimethylgallium G2 in the raw material gas G is introduced into the second passage 17b of the first flow channel 20. The introduced oxygen G1 and trimethylgallium G2 undergo a gas-phase reaction downstream of the edge 12b of the upper partition plate 12 and the edge 12b of the lower partition plate 12.

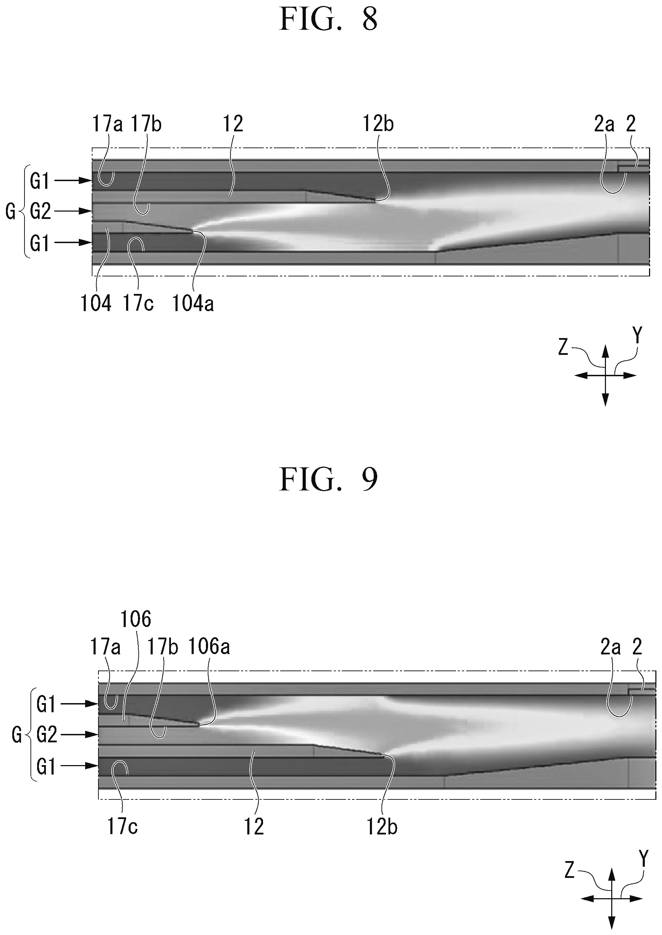

FIG. 8 is a cross-sectional view illustrating effects due to the length of partition plates according to comparative embodiment 2.

As shown in FIG. 8, the lower partition plate 104 is formed to be shorter than the upper partition plate 12 in comparative embodiment 2. In the first flow channel 20 of comparative embodiment 2, oxygen (O₂ + carrier gas (inert gas such as Ar)) G1 in the raw material gas G is introduced into the first passage 17a and the third passage 17c. Furthermore, trimethylgallium G2 in the raw material gas G is introduced into the second passage 17b of the first flow channel 20. The introduced oxygen G1 and trimethylgallium G2 react downstream of the edge 104a of the lower partition plate 104. Furthermore, oxygen G1 and trimethylgallium G2 undergo a gas-phase reaction upstream of the edge 12b of the upper partition plate 12.

FIG. 9 is a cross-sectional view illustrating effects due to the length of partition plates according to comparative embodiment 3.

As shown in FIG. 9, the upper partition plate 106 in comparative embodiment 3 is formed to be shorter than the lower partition plate 12. In the first flow channel 20 of comparative embodiment 3, oxygen (O₂ + carrier gas (inert gas such as Ar)) G1 in the raw material gas G is introduced into the first passage 17a and the third passage 17c. Furthermore, trimethylgallium G2 in the raw material gas G is introduced into the second passage 17b of the first flow channel 20. The introduced oxygen G1 and trimethylgallium G2 react downstream of the edge 106a of the upper partition plate 106. Furthermore, the oxygen G1 and trimethylgallium G2 undergo a gas-phase reaction upstream of the edge 12b of the lower partition plate 12.

A simulation was performed to investigate the difference in the deposition of the raw material gas on the ceiling plate caused by differences in the length of the partition plates. FIG. 10 is a graph showing the growth rate on the substrate surface by the raw material gas with respect to the length of the partition plates. In FIG. 10, the vertical axis shows the growth rate on the substrate surface 2a. The horizontal axis shows the position of the substrate surface 2a from edge 12b of the partition plate 12. Graph Gr3 is a graph showing the growth state on the substrate surface 2a in the present embodiment. Graph Gr4 is a graph showing the growth state on the substrate surface 2a in comparative embodiment 2. Graph Gr5 is a graph showing the growth state on the substrate surface 2a in comparative embodiment 3.

As shown in FIG. 10, it can be seen that the graph Gr3 of the present embodiment has a faster thin film growth rate on the substrate surface 2a due to the raw material gas G than the graph Gr4 of comparative embodiment 2 and the graph Gr5 of comparative embodiment 3. That is, in the present embodiment, oxygen G1 and trimethylgallium G2 undergo a gas-phase reaction downstream compared to comparative embodiments 2 and 3. As a result, the present embodiment can achieve a faster thin film growth rate on the substrate surface 2a than comparative embodiments 2 and 3. For example, the thin film growth rate of the present embodiment can be increased by 10% compared to comparative embodiments 2 and 3.

### (Inclination Angle of Sloped Surface of Partition Plate)

Next, the reason for setting the inclination angle θ1 of the sloped surface 31 of the partition plate 12 in the range of 3° to 30° will be explained in detail with reference to FIGS. 11 through 17.

FIG. 11 is a cross-sectional view illustrating effects due to the inclination angle of the sloped surface of the partition plate according to the present embodiment.

As shown in FIG. 11, the inclination angle θ1 of the sloped surface 31 of the partition plate 12 according to the present embodiment is set to θ1 = 7.5°. This suppresses the deposition rate on the ceiling 15 due to the gas-phase reaction of oxygen (G1) and trimethylgallium (G2) downstream of the edge 12b of the partition plate 12.

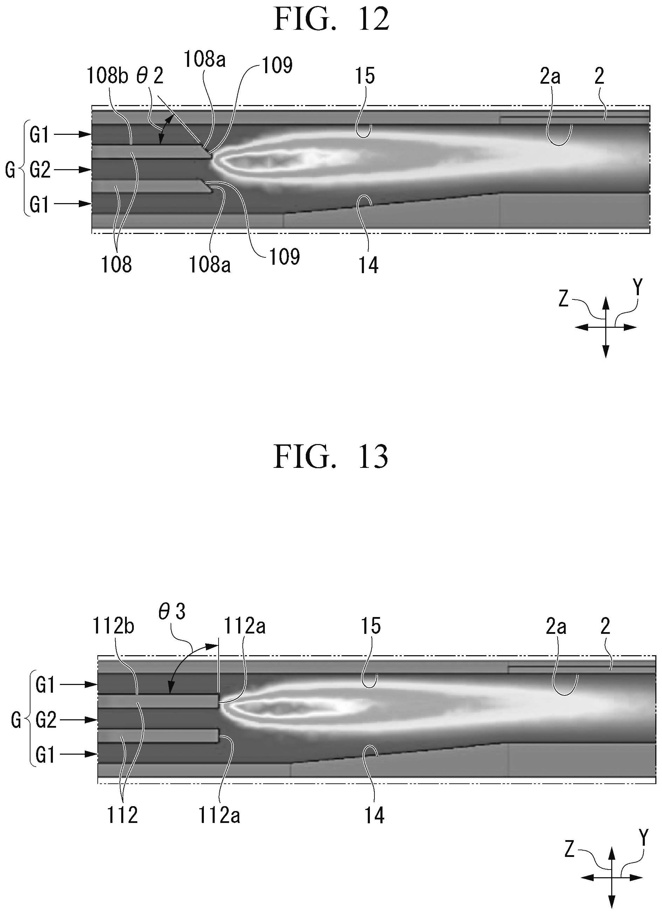

FIG. 12 is a cross-sectional view illustrating effects due to the inclination angle of the sloped surface of the partition plate according to comparative embodiment 4.

As shown in FIG. 12, the inclination angle θ2 of the sloped surface 109 of the partition plate 108 according to comparative embodiment 4 is set to θ2 = 45° with respect to the upper surface 108b. As a result, on the downstream side of the edge 108a of the partition plate 108, the deposition rate on the ceiling 15 due to the gas-phase reaction of oxygen G1 and trimethylgallium G2 is faster on the upstream side compared to the present embodiment.

FIG. 13 is a cross-sectional view illustrating a state in which a sloped surface is not formed on the partition plate according to comparative embodiment 5.

As shown in FIG. 13, a sloped surface is not formed on the partition plate 112 of comparative embodiment 5. That is, the edge 112a of the partition plate 112 of comparative embodiment 5 is set at an angle θ3 of θ3 = 90° relative to the upper surface 112b. As a result, the deposition rate on the ceiling 15 due to the gas-phase reaction of oxygen G1 and trimethylgallium G2 is faster on the upstream side of the edge 112a of the partition plate 112 compared to the present embodiment.

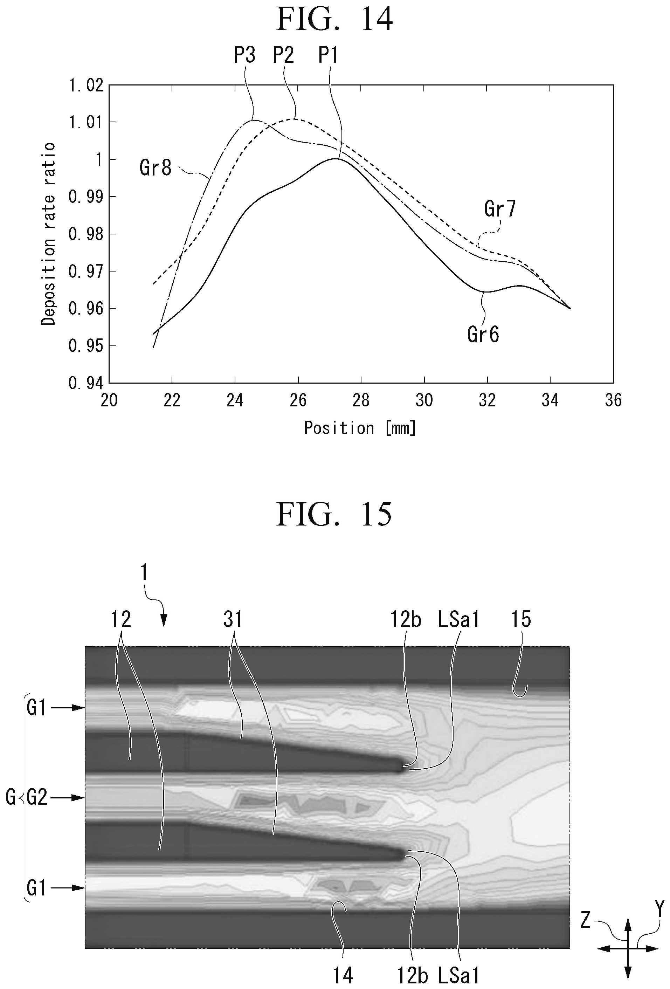

A simulation was performed to investigate the difference in deposition of the raw material gas on the ceiling plate caused by differences in the inclination angle of the partition plate. FIG. 14 is a graph showing the deposition rate ratio of the raw material gas on the ceiling with respect to the inclination angle of the partition plate. In FIG. 14, the vertical axis shows the deposition rate ratio of the raw material gas G on the ceiling 15 downstream of the partition plate 12. The horizontal axis shows the downstream position from the edges 12b, 108a, 112a of the partition plates 12, 108, 112. Graph Gr6 is a graph showing the deposition rate ratio using the partition plate 12 in the present embodiment. Graph Gr7 is a graph showing the deposition rate ratio using the partition plate 108 in comparative embodiment 4. Graph Gr8 is a graph showing the deposition rate ratio using the partition plate 112 in comparative embodiment 5.

As shown in FIGS. 11 to 14, the peak of the deposition rate ratio in graph Gr6 of the present embodiment is P1. The peak of the deposition rate ratio in graph Gr7 of comparative embodiment 4 is P2. The peak of the deposition rate ratio in graph Gr8 of comparative embodiment 5 is P3. Graphs Gr6 and Gr8 show that the peak of the deposition rate ratio P1 in the present embodiment is located downstream of the peak of the deposition rate ratio in comparative embodiment 4 and the peak of the deposition rate ratio in comparative embodiment 5.

Therefore, the peak P1 of the deposition rate ratio in the present embodiment can be shifted closer to the substrate surface 2a compared to comparative embodiment 4 and comparative embodiment 5. As a result, the partition plate 12 of the present embodiment can increase the thin film growth rate on the substrate surface 2a compared to the partition plate 108 of comparative embodiment 4 and the partition plate 112 of comparative embodiment 5. Furthermore, by shifting the peak P1 of the deposition rate by adjusting the inclination angle of the edge of the partition plate 12 of the present embodiment closer to the substrate surface 2a compared to comparative embodiment 4 and comparative embodiment 5, deposits (particles) such as dust and foreign matter adhering to the ceiling 15 can be reduced.

FIG. 15 is a cross-sectional view illustrating the low-velocity region at the edge of the partition plates according to the present embodiment.

As shown in FIG. 15, the partition plate 12 according to a present embodiment keeps the low-velocity region Lsa1 of the raw material gas G small near the downstream side of the edge 12b. Therefore, the partition plate 12 can keep the stagnation of the flow of the raw material gas G small near the downstream side of the edge 12b.

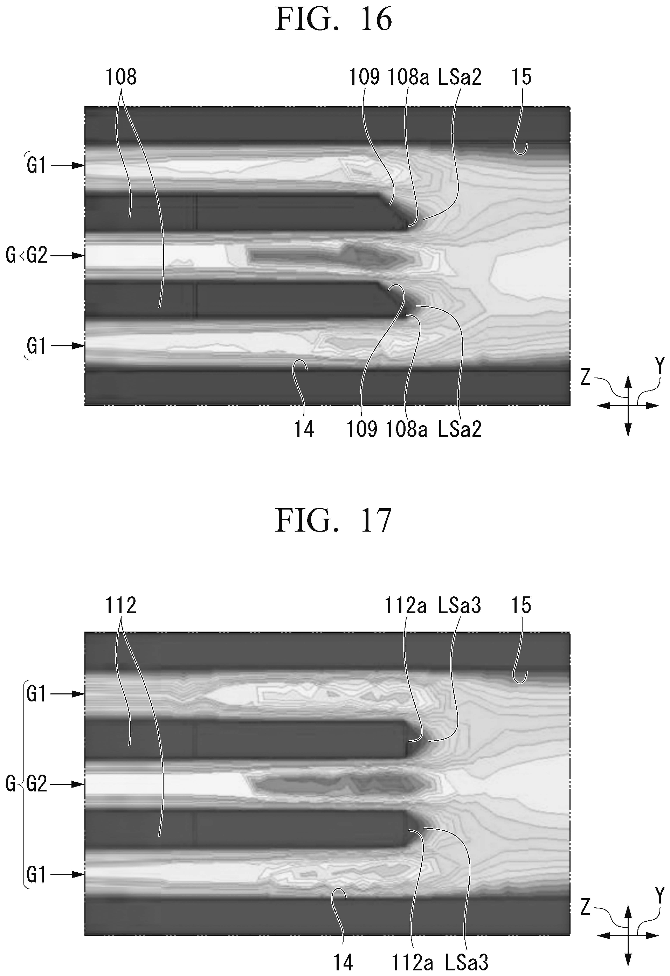

FIG. 16 is a cross-sectional view illustrating the low-velocity region at the edge of the partition plates according to comparative embodiment 4.

As shown in FIG. 16, in the partition plate 108 of comparative embodiment 4, the low-velocity region Lsa2 of the raw material gas G near the downstream side of the edge 108a extends further downstream than the low-velocity region Lsa1 of the present embodiment. Therefore, in the partition plate 108, the stagnation of the flow caused by the raw material gas G near the downstream side of the edge 108a is greater than in the partition plate 12 of the present embodiment.

FIG. 17 is a cross-sectional view illustrating the low-velocity region at the edge of the partition plates according to comparative embodiment 5.

As shown in FIG. 17, in the partition plate 112 of comparative embodiment 5, the low-velocity region Lsa3 of the raw material gas G near the downstream side of the edge 112a extends further downstream than the low-velocity region Lsa2 in the present embodiment. Therefore, in the partition plate 112, the stagnation of the flow caused by the raw material gas G near the downstream side of the edge 112a is greater than in the partition plate 12 of the present embodiment.

As shown in FIGS. 15 to 17, the partition plate 12 of the present embodiment can reduce stagnation of the flow caused by the raw material gas G near the downstream side of the edge 12b compared to the partition plate 108 of comparative embodiment 4 and the partition plate 112 of comparative embodiment 5.

When there is significant stagnation of the flow of the raw material gas G near the downstream side of each edge 108 a, 112 a, as in comparative embodiments 4 and 5, there is a high possibility that the introduced raw material gas G will remain near the downstream side of the edges 108 a, 112 a for a long time and cause a gas-phase reaction. For this reason, powder is likely to be formed in the gas-phase of the raw material gas G by a gas-phase reaction near the downstream side of the edge 108 a of the partition plate 108 in comparative embodiment 4, and near the downstream side of the edge 112 a of the partition plate 112 in comparative embodiment 5.

In contrast, in the partition plate 12 of the present embodiment, stagnation of the flow of the raw material gas G is kept small near the downstream side of the edge 12 b. Therefore, in the present embodiment, it is possible to suppress the formation of powder in the gas-phase of the raw material gas G due to a gas-phase reaction near the downstream side of the edge 12 b of the partition plate 12. This makes it possible to suppress the adhesion of deposits of the raw material gas G to the ceiling 15 on the upstream side of the substrate surface 2 a.

Although the inclination angle θ1 of the sloped surface 31 of the partition plate 12 of the present embodiment shown in FIG. 11 is set to θ1 = 7.5°, the same effects and advantages as those of θ1 = 7.5° can be obtained by setting the inclination angle θ1 in the range of θ1 = 3° to 30°. Furthermore, it is preferable to set the inclination angle θ1 in the range of θ1 = 3° to 8°.

In the vapor phase growth device 1 according to the present embodiments described above, as shown in FIGS. 11 to 17, the gas passage 14 is partitioned into multiple layers by the partition plate 12 upstream of the substrate surface 2a. Furthermore, the sloped surface 31 is formed at the edge of the partition plate 12 on the substrate surface 2a side. These shift the peak P1 of the deposition rate ratio of the raw material gas G to the gas passage 14 closer to the substrate surface 2a, thereby increasing the thin film growth rate on the substrate surface 2a and improving productivity. Furthermore, the shifting the peak P1 of the deposition rate ratio of the raw material gas G closer to the substrate surface 2a reduces the amount of deposits, such as dust and foreign matter, that adhere to the gas passage 14. This reduces the number of times deposits from the gas passage 14 need to be removed, thereby contributing to cost reduction.

In addition, stagnation of the flow of the raw material gas G can be minimized near the downstream side of the edge 12b of the partition plate 12. This prevents powder from being formed due to the gas-phase reaction of the raw material gas G near the downstream side of the edge 12b of the partition plate 12. This prevents deposits of the raw material gas G from adhering to the gas passage 14 upstream of the substrate surface 2a. This reduces the number of times deposits accumulated in the gas passage 14 need to be removed.

In this way, by increasing the growth rate of the thin film on the substrate surface 2a and further reducing deposits adhering to the gas passage 14, the cost of the substrate 2 can be reduced and the productivity of the substrate 2 can be increased.

In addition, as shown in FIGS. 4 to 6, the sloped surface 31 of the partition plate 12 is inclined away from the substrate surface 2a. Therefore, the partition plate 12 can minimize deposits of the raw material gas G on the upstream side of the substrate surface 2a. This allows the partition plate 12 to efficiently grow a thin film on the substrate surface 2a.

Furthermore, as shown in FIG. 3, the first gas passage 17 of the gas passage 14 is partitioned into three layers by the partition plate 12. This allows the first gas passage 17 to be partitioned into a central second passage 17b and two side first and third passages 17a and 17c. This allows, for example, trimethylgallium G2 to be introduced into the central second passage 17b of the three layers, and oxygen G1 to be introduced into the two side first and third passages 17a and 17c. This allows oxygen G1 and trimethylgallium G2 to be supplied toward the substrate 2 while suppressing a gas-phase reaction between oxygen G1 and trimethylgallium G2 downstream of the partition plate 12 before they are supplied to the substrate 2.

In addition, as shown in FIGS. 7 to 10, the partition plates 12 that separate the gas passage 14 into three layers are all the same length. This increases the growth rate of the raw material gas G downstream of the edge 12b of the partition plate 12. This increases the growth rate of the thin film on the substrate surface 2a.

In addition, the substrate surface 2a of the substrate 2 is placed facing downward. Therefore, for example, dust or foreign matter adhering to the substrate surface 2a can be dropped downward. This allows a thin film to be favorably grown on the substrate surface 2a.

The technical scope of the present invention is not limited to the above-described embodiments, and various modifications can be made without departing from the spirit of the present invention.

In addition, within the scope of the spirit of the present invention, the components in the above-described embodiments may be replaced with well-known components as appropriate, and the above-described modifications may be combined as appropriate.

### EXPLANATION OF REFERENCE NUMERAL

- 1: vapor phase growth device
- 2: substrate
- 2a: substrate surface (surface of substrate)
- 10: flow channel
- 12: partition plate
- 12b: edge of partition plate
- 14: gas passage
- 17: first gas passage
- 20: first flow channel
- 31: sloped surface
- G: raw material gas

## Claims

1. A vapor phase growth device comprising:
a flow channel comprising a gas passage for guiding a raw material gas, a substrate disposed in the gas passage, and which is configured to guide the raw material gas to a surface of a substrate through the gas passage; and
a partition plate that partitions the gas passage into multiple layers upstream of the surface of the substrate, the edge of which on the surface side of the substrate is formed into a sloped surface.

2. The vapor phase growth device according to Claim 1,
wherein the sloped surface is inclined away from the surface of the substrate.

3. The vapor phase growth device according to Claim 2,
wherein the plurality of layers is three layers.

4. The vapor phase growth device according to Claim 3,
wherein the partition plates that divides the plurality of layers into three layers have the same length.

5. The vapor phase growth device according to Claim 1,
wherein the surface of the substrate is positioned facing downward.
